# EUROPEAN PATENT APPLICATION

(11) **EP 4 098 954 A1**
(43) Date of publication of application: **07.12.2022**
(21) Application number: 22176034.1
(22) Date of filing: 30.05.2022
(51) Int. Cl.: F25B 13/00, F28D 1/00, H01L 35/28

(54) **HEAT PUMP SYSTEM**

(30) Priority: 02.06.2021 JP 2021093008
(71) Applicant: Panasonic Intellectual Property Management Co., Ltd., Osaka-shi, Osaka 540-6207 (JP)
(72) Inventor: ADACHI, Kensuke, Osaka 540-6207 (JP); SAKASHITA, Satoshi, Osaka 540-6207 (JP)
(74) Representative: Eisenführ Speiser

(57) **Abstract**

A heat pump system (100) including a first heat exchanger (4), a compressor (6), a second heat exchanger (5), and an expansion mechanism (7) that are sequentially connected by a refrigerant pipe that circulates a refrigerant and a thermoelectric member (20). The thermoelectric member is a member that converts a temperature difference into electric energy. The thermoelectric member is disposed in at least one of the first heat exchanger and the second heat exchanger.

## Description

### BACKGROUND

### 1. Technical Field

The present disclosure relates to a heat pump system.

### 2. Description of the Related Art

As a heat pump system, for example, PTL 1 discloses a refrigerating machine that uses exhaust heat produced by operation of the refrigerating machine.

PTL 1 discloses a refrigerating machine including a thermoelectric element for converting a temperature difference into electric energy. The refrigerating machine described in PTL 1 includes a plurality of the thermoelectric elements, one of the thermoelectric elements is positioned in a refrigerant pipe, and the other of the thermoelectric elements is positioned in the ambient air atmosphere.

### Citation List

### Patent Literature

PTL 1: Unexamined Japanese Patent Publication No. 2013-250030

### SUMMARY

However, the refrigerating machine described in PTL 1 still has room for improvement in terms of improvement in energy efficiency.

Therefore, the present disclosure provides a heat pump system capable of improving energy efficiency.

A heat pump system of one aspect of the present disclosure includes a first heat exchanger, a compressor, a second heat exchanger, and an expansion mechanism that are sequentially connected by a refrigerant pipe for circulating a refrigerant. The heat pump system of one aspect of the present disclosure includes a thermoelectric member that is disposed in at least one of the first heat exchanger and the second heat exchanger and converts a temperature difference into electric energy.

The heat pump system of one aspect of the present disclosure can improve energy efficiency.

### BRIEF DESCRIPTION OF THE DRAWINGS

Fig. 1 is a schematic diagram illustrating a configuration of a heat pump system according to an exemplary embodiment;
Fig. 2 is a schematic diagram illustrating a configuration of a second heat exchanger;
Fig. 3 is a view illustrating the configuration of the second heat exchanger in which a thermoelectric member is disposed;
Fig. 4 is a cross-sectional view taken along line A-A of Fig. 3, illustrating the configuration of the second heat exchanger;
Fig. 5 is a cross-sectional view illustrating a configuration of a thermoelectric element;
Fig. 6 is a partial side view illustrating the configuration of the second heat exchanger;
Fig. 7 is a schematic diagram illustrating a configuration of an electronic component related to the second heat exchanger;
Fig. 8 is a graph illustrating temperature distribution of external air around a fin;
Fig. 9 is a view illustrating arrangement of thermoelectric elements of a first modification;
Fig. 10A is a view illustrating arrangement of thermoelectric elements of a second modification;
Fig. 10B is a partially enlarged view illustrating a configuration of the thermoelectric element in Fig. 10A; and
Fig. 11 is a cross-sectional view illustrating a configuration of a thermoelectric element of a third modification.

### DETAILED DESCRIPTIONS

### (Background to present disclosure)

Heat pump systems generally have high coefficient of performance (COP), and can improve energy efficiency by recovering a part of exhaust heat of the system and reusing the recovered heat in the heat pump systems.

However, in recent years, it is required to further improve energy efficiency of heat pump systems. Therefore, heat pump systems are required to generate larger electric power using thermoelectric members.

Therefore, the inventors of the present invention have identified, as a heat exchanger, a place where a large amount of exhaust heat is performed and a temperature difference is likely to be generated in the heat pump system. The inventors of the present invention have found a configuration in which disposing a thermoelectric member in a heat exchanger increases a temperature difference in the thermoelectric member and thus increase a power generation amount of the thermoelectric member.

The inventors of the present invention have decided to provide the following disclosure based on these novel findings.

A heat pump system of a first aspect of the present disclosure includes the first heat exchanger, the compressor, the second heat exchanger, and the expansion mechanism that are sequentially connected by the refrigerant pipe for circulating the refrigerant. The heat pump system of the first aspect of the present disclosure includes the thermoelectric member that is disposed in at least one of the first heat exchanger and the second heat exchanger and converts a temperature difference into electric energy.

With such configuration, the thermoelectric member can efficiently generate power due to the temperature difference generated in the first heat exchanger or the second heat exchanger. Therefore, the heat pump system of the first aspect of the present disclosure can improve energy efficiency.

In a heat pump system of a second aspect of the present disclosure, the second heat exchanger may be disposed outdoors, and the thermoelectric member may have a first surface that is in physical contact with the second heat exchanger, and a second surface that opposes the first surface and faces external air.

With such configuration, a temperature difference is generated between the first surface and the second surface due to heat radiation from the second heat exchanger to the external air, so that the thermoelectric member can efficiently generate power.

In a heat pump system of a third aspect of the present disclosure, the thermoelectric member may be a vertical thermoelectric element.

With such configuration, the vertical thermoelectric element does not inhibit heat exchange of the heat pump system, and thus can further improve energy efficiency.

In a heat pump system of a fourth aspect of the present disclosure, the thermoelectric member may have a magnetic membrane formed of a magnetic material.

With such configuration, the thermoelectric member can efficiently generate power due to the anomalous Nernst effect, and can further improve energy efficiency of the heat pump system.

In a heat pump system of a fifth aspect of the present disclosure, the thermoelectric member may include an insulating film that forms the first surface and is formed of a magnetic insulator, and a conductive membrane that is disposed on the insulating film, forms the second surface, and is formed of a conductor.

With such configuration, the thermoelectric member can efficiently generate power due to the spin Seebeck effect, and can further improve energy efficiency of the heat pump system.

In a heat pump system of a sixth aspect of the present disclosure, the second heat exchanger may include a plurality of fins and a heat transfer flow channel mechanism that is in contact with the plurality of fins and circulates the refrigerant. A plurality of the thermoelectric members are provided, and the plurality of thermoelectric members may be arranged in a line continuous to the plurality of respective fins.

With such configuration, the thermoelectric member can efficiently generate power due to the temperature difference generated between the external air and the fins.

In a heat pump system of a seventh aspect of the present disclosure, the plurality of thermoelectric members may be connected in series for each fin.

With such configuration, due to the lengthened thermoelectric member, the heat pump system of the seventh aspect of the present disclosure can increase the power generation amount in the thermoelectric member.

In a heat pump system of an eighth aspect of the present disclosure, the plurality of thermoelectric members may meander.

With such configuration, due to the lengthened thermoelectric member, the heat pump system of the eighth aspect of the present disclosure can further increase the power generation amount in the thermoelectric member.

A heat pump system of a ninth aspect of the present disclosure may further include a fan for supplying external air to the plurality of fins.

With such configuration, the heat pump system of the ninth aspect of the present disclosure can form a flow of external air with respect to the second heat exchanger to maintain the temperature difference between the fins and the external air. Therefore, the heat pump system of the ninth aspect of the present disclosure can increase the power generation amount in the thermoelectric member.

In a heat pump system of a tenth aspect of the present disclosure, the plurality of thermoelectric members may be arranged upstream with respect to the external air supplied by the fan on the main surfaces of the plurality of fins.

With such configuration, the thermoelectric member is exposed to external air, the temperature difference between the first surface and the second surface of the thermoelectric member is maintained, and therefore the heat pump system of the tenth aspect of the present disclosure can increase the power generation amount in the thermoelectric member.

In a heat pump system of an 11th aspect of the present disclosure, the plurality of thermoelectric members may be arranged at upstream ends of the plurality of fins with respect to the external air supplied by the fan.

With such configuration, the thermoelectric member is exposed to more external air, the temperature difference between the first surface and the second surface of the thermoelectric member is maintained, and therefore the heat pump system of the 11th aspect of the present disclosure can further increase the power generation amount in the thermoelectric member.

In a heat pump system of a 12th aspect of the present disclosure, the plurality of thermoelectric members may be arranged in the plurality of fins around the heat transfer flow channel mechanism.

With such configuration, since the thermoelectric member is disposed at a position where heat exchange is performed, the temperature difference between the first surface and the second surface of the thermoelectric member is maintained. Therefore, the heat pump system of the 12th aspect of the present disclosure can increase the power generation amount in the thermoelectric member.

In a heat pump system of a 13th aspect of the present disclosure, the plurality of fins may include protrusions protruding from the main surfaces forming the fins, and the thermoelectric members may be arranged along the protrusions.

With such configuration, the thermoelectric member is exposed to external air, the temperature difference between the first surface and the second surface of the thermoelectric member is maintained, and therefore the heat pump system of the 13th aspect of the present disclosure can increase the power generation amount in the thermoelectric member.

In a heat pump system of a 14th aspect of the present disclosure, the plurality of fins may be arrayed in a first row and a second row arranged adjacent to a downstream side of the first row. The heat transfer flow channel mechanism may have a heat transfer tube penetrating the plurality of fins, and the heat transfer tube penetrating the first row and the heat transfer tube penetrating the second row may be shifted from each other with respect to a supply direction of external air by the fan. The plurality of thermoelectric members may be arranged upstream with respect to the external air supplied by the fan on the main surfaces of the plurality of fins in the first row and the second row.

With such configuration, due to the lengthened thermoelectric member, the heat pump system of the 14th aspect of the present disclosure can further increase the power generation amount in the thermoelectric member.

A heat pump system of a 15th aspect of the present disclosure may further include a power storage that is connected to the thermoelectric member and stores the electric energy converted by the thermoelectric member.

With such configuration, the heat pump system of the 15th aspect of the present disclosure can store the electric power generated by the thermoelectric member.

A heat pump system of a 16th aspect of the present disclosure may further include a four-way valve that changes a direction in which a refrigerant flows in a refrigerant pipe, and a rectifier that is connected to the thermoelectric member and changes a direction of a current according to the direction in which the refrigerant flows.

With such configuration, the heat pump system of the 16th aspect of the present disclosure can be applied to, for example, an air conditioner that changes a flow direction of a refrigerant in a refrigerant pipe.

In a heat pump system of a 17th aspect of the present disclosure, a terminal connected to the thermoelectric member may be disposed above the second heat exchanger.

With such configuration, in the heat pump system of the 17th aspect of the present disclosure, the terminal can be suppressed from hindering drainage of water adhering to the second heat exchanger due to heat exchange.

### (Exemplary embodiment)

Heat pump system 100 according to an exemplary embodiment of the present disclosure will be described. In the following description, an air conditioner in cooling operation will be described as an example of heat pump system 100 according to the exemplary embodiment, but heat pump system 100 according to the exemplary embodiment is not limited to the air conditioner.

### [Overall configuration]

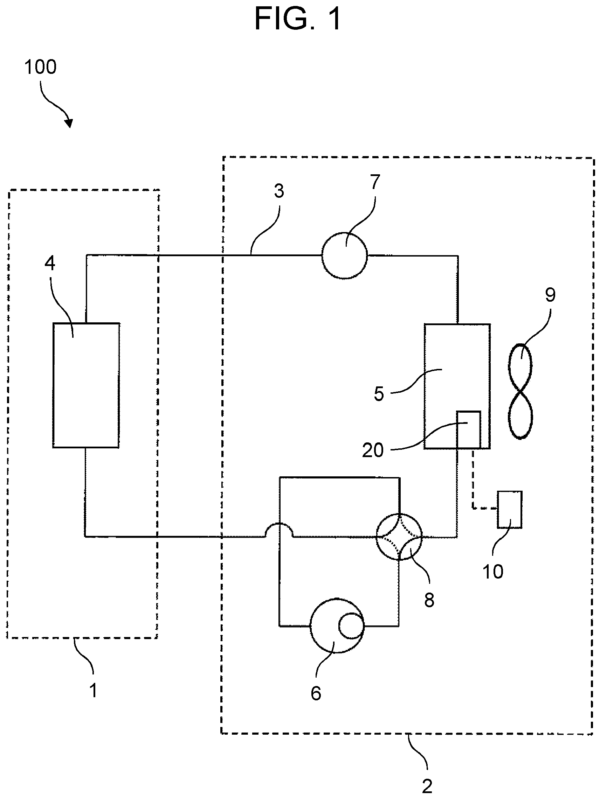

Fig. 1 is a schematic diagram illustrating the configuration of heat pump system 100 according to the exemplary embodiment of the present disclosure. As illustrated in Fig. 1, heat pump system 100 includes indoor equipment 1 and outdoor equipment 2. Indoor equipment 1 and outdoor equipment 2 are connected via refrigerant pipe 3.

Indoor equipment 1 includes first heat exchanger 4 and a part of refrigerant pipe 3. Indoor equipment 1 is disposed indoors.

Outdoor equipment 2 includes second heat exchanger 5, thermoelectric member 20, compressor 6, expansion mechanism 7, four-way valve 8, fan 9, controller 10, and a part of refrigerant pipe 3. Outdoor equipment 2 is disposed outdoors.

Constituent elements of indoor equipment 1 and outdoor equipment 2 will be described.

### <First heat exchanger>

For example, in cooling operation, first heat exchanger 4 exchanges heat with air to evaporate the refrigerant flowing into first heat exchanger 4.

### <Refrigerant pipe>

Refrigerant pipe 3 is disposed so as to connect first heat exchanger 4, compressor 6, four-way valve 8, second heat exchanger 5, and expansion mechanism 7. For example, refrigerant pipe 3 sequentially connects first heat exchanger 4, compressor 6, four-way valve 8, second heat exchanger 5, and expansion mechanism 7. Refrigerant pipe 3 has a flow channel through which a refrigerant flows inside refrigerant pipe 3, and circulates the refrigerant. For example, refrigerant pipe 3 has a hollow cylindrical shape.

### <Second heat exchanger>

For example, in cooling operation, second heat exchanger 5 exchanges heat with air to condense the refrigerant flowing into second heat exchanger 5. As described later, second heat exchanger 5 includes a plurality of fins 11a and 11b and heat transfer tube 14. The plurality of fins 11a and 11b include a plurality of thin metal plates, and are arranged such that the surfaces of the respective metal plates become parallel to each other. Heat transfer tube 14 is disposed orthogonal to the surfaces of fins 11a and 11b and penetrate fins 11a and 11b. Heat transfer tube 14 is connected to refrigerant pipe 3 and circulates the refrigerant.

### <Thermoelectric member>

Thermoelectric member 20 is a member that is disposed in second heat exchanger 5 and converts a temperature difference into electric energy. In other words, thermoelectric member 20 generates power according to the temperature difference formed in thermoelectric member 20. Thermoelectric member 20 includes an element (hereinafter, thermoelectric element 50) that exerts a thermoelectric effect. Thermoelectric member 20 may include other electronic components such as a connector and a wire. As described later, thermoelectric member 20 is disposed in physical contact with the surfaces of fin 11a of second heat exchanger 5.

### <Compressor>

Compressor 6 is connected to first heat exchanger 4 and four-way valve 8 by refrigerant pipe 3. Compressor 6 is used to compress the refrigerant flowing in from refrigerant pipe 3.

### <Expansion mechanism>

Expansion mechanism 7 is connected to first heat exchanger 4 and second heat exchanger 5 by refrigerant pipe 3. Expansion mechanism 7 is used to expand the refrigerant flowing from refrigerant pipe 3. For example, expansion mechanism 7 is an expansion valve.

### <Four-way valve>

Four-way valve 8 is connected to compressor 6, first heat exchanger 4, and second heat exchanger 5 by refrigerant pipe 3. In cooling operation, four-way valve 8 sends the refrigerant flowing out from compressor 6 to second heat exchanger 5 along the flow direction of the refrigerant. On the other hand, four-way valve 8 changes the flow direction of the refrigerant according to the operation mode (cooling operation or heating operation) of heat pump system 100.

### <Fan>

Fan 9 is disposed around second heat exchanger 5 and supplies external air to second heat exchanger 5. The supplied external air is used for heat exchange of second heat exchanger 5.

### <Controller>

Controller 10 includes an electronic circuit that controls heat pump system 100. Controller 10 includes, for example, a memory that stores a program and a processing circuit corresponding to a processor such as a central processing unit (CPU), and these elements may function as controller 10 when the processor executes the program. For example, controller 10 controls the operation mode of heat pump system 100 between cooling operation and heating operation. Controller 10 is electrically connected to thermoelectric member 20.

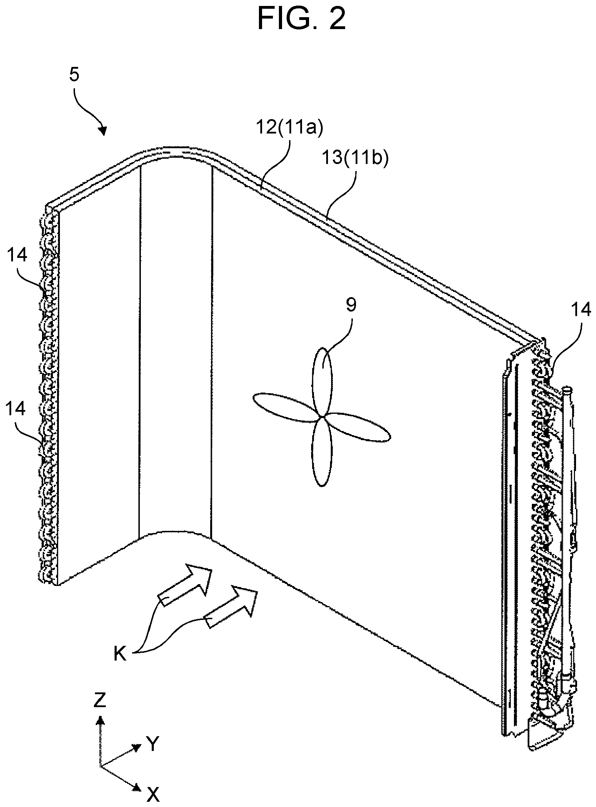

Next, the configuration of second heat exchanger 5 will be described in more detail with reference to Figs. 2 to 4.

Fig. 2 is a schematic diagram illustrating the configuration of second heat exchanger 5. In Fig. 2, individual fins 11a and 11b and thermoelectric member 20 are not illustrated for the sake of convenience. As illustrated in Fig. 2, in second heat exchanger 5, the plurality of fins 11a are arranged to form first row 12, and the plurality of fins 11b are arranged to form second row 13. In respective rows, fins 11a and 11b are arranged such that the surfaces of fins 11a and 11b become parallel to each other. First row 12 and second row 13 are arranged along the short direction (Y direction) of fins 11a and 11b and are adjacent to each other.

In second heat exchanger 5, heat transfer tube 14 is formed to penetrate fins 11a and 11b in first row 12 and second row 13, respectively.

Fan 9 is disposed around second heat exchanger 5. Fan 9 is disposed on the -Y direction side of second row 13. The external air is sucked by rotation of fan 9 and supplied to second heat exchanger 5 along arrow K. Arrow K indicates a supply direction of external air by fan 9. In the present exemplary embodiment, the external air sequentially reaches first row 12 and second row 13 along the short direction (Y direction) of fins 11a and 11b. That is, first row 12 is disposed on the upstream side of second row 13 with respect to the flow of external air formed by fan 9.

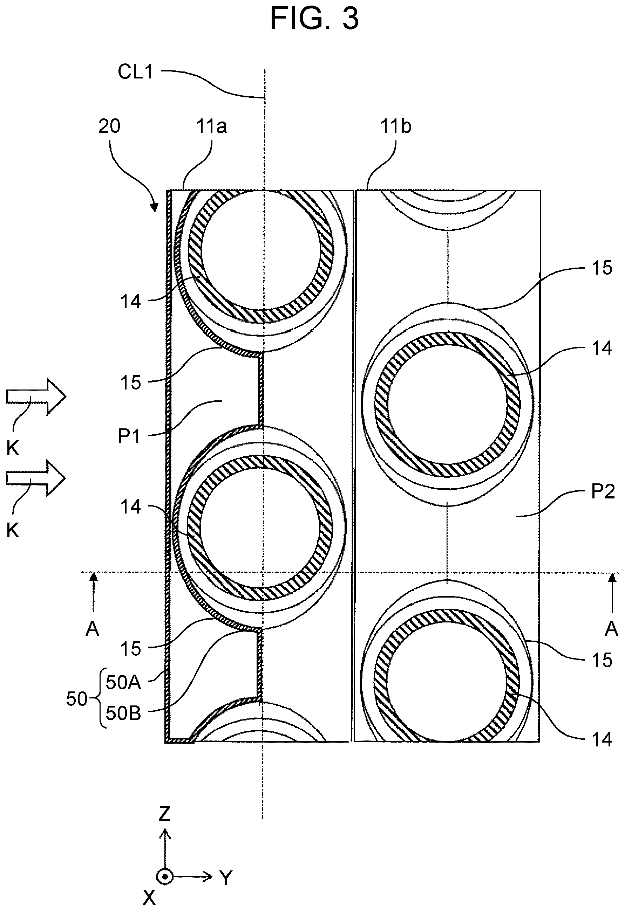

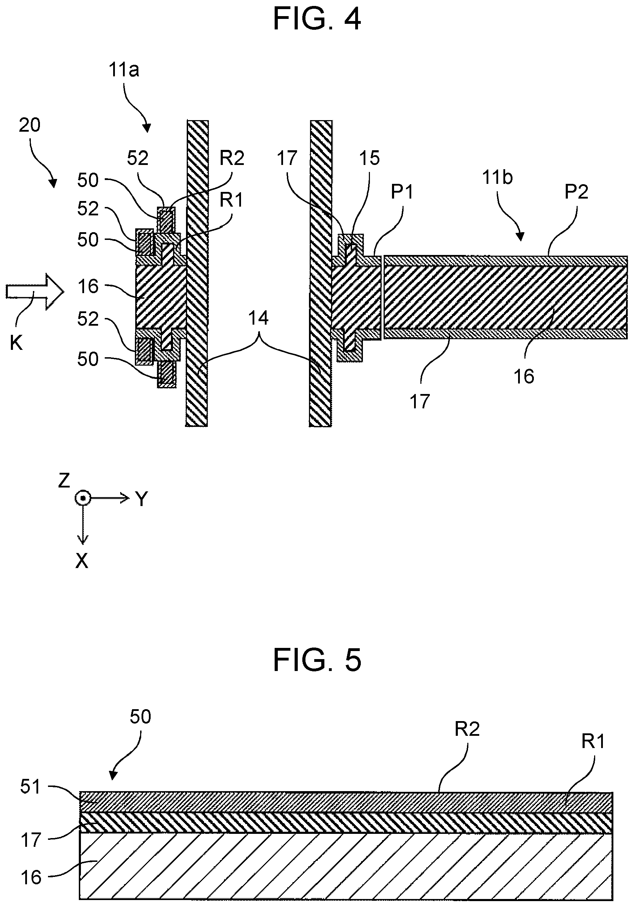

Fig. 3 is a view illustrating the configuration of second heat exchanger 5 in which thermoelectric member 20 is disposed. Fig. 4 is a cross-sectional view taken along line A-A in Fig. 3, illustrating the configuration of second heat exchanger 5.

Figs. 3 and 4 illustrate one fin 11a in first row 12 and one fin 11b in second row 13 adjacent to fin 11a. As illustrated in Fig. 3, heat transfer tube 14 penetrates fins 11a and 11b at different positions in the long direction (Z direction) of fins 11a and 11b. That is, heat transfer tube 14 penetrating first row 12 and heat transfer tube 14 penetrating second row 13 are shifted from each other with respect to the supply direction (arrow K) of external air by fan 9. More specifically, heat transfer tube 14 in second row 13 is positioned between two heat transfer tubes 14 adjacent to each other in first row 12 as viewed from the supply direction (arrow K) of the external air by fan 9.

As illustrated in Figs. 3 and 4, fins 11a and 11b form protrusions 15 protruding from main surfaces P1 and P2 of respective fins 11a and 11b around heat transfer tubes 14. In other words, protrusion 15 protrudes in an X direction. Protrusion 15 may be formed along the entire perimeter of the outer perimeter of heat transfer tube 14. Since protruding from main surfaces P1 and P2 of fins 11a and 11b, protrusion 15 is easily exposed to the external air flowing along main surfaces PI and P2, formation of a boundary layer is suppressed in protrusion 15, and the external air is less likely to stay. Therefore, the temperature difference between fins 11a and 11b and external air is maintained.

Fins 11a and 11b have base material 16 formed of aluminum. As illustrated in Fig. 4, fins 11a and 11b have insulating film 17 of aluminum oxide covering base material 16. Insulating film 17 prevents corrosion of base material 16.

The configuration of thermoelectric member 20 will be described in detail with reference to Figs. 3 to 5. Fig. 5 is a cross-sectional view illustrating the configuration of thermoelectric element 50.

As illustrated in Figs. 3 and 4, thermoelectric member 20 includes thermoelectric element 50. Although not illustrated, thermoelectric member 20 may include other electronic components such as a connector and a wire in addition to thermoelectric element 50. Thermoelectric element 50 is disposed on fin 11a of second heat exchanger 5. More specifically, thermoelectric element 50 is disposed on main surface PI of fin 11a. As illustrated in Fig. 4, thermoelectric element 50 is disposed on both main surface PI of fin 11a and a main surface opposite to main surface P1. In the present exemplary embodiment, thermoelectric element 50 is a vertical thermoelectric element. The vertical thermoelectric element generates power perpendicularly to the direction in which a temperature difference is generated. In the present exemplary embodiment, thermoelectric element 50 generates power perpendicularly to main surface PI.

As illustrated in Fig. 5, thermoelectric element 50 includes magnetic membrane 51. Magnetic membrane 51 is formed of a magnetic material. As the magnetic material, a magnetic metal, a semimetal, or a Wile magnetic material may be used. Magnetic membrane 51 has first surface R1 physically in contact with second heat exchanger 5 and second surface R2 facing the external air. First surface R1 is disposed in physical contact with insulating film 17 of fin 11a. Second surface R2 opposes first surface R1 and is directed in a direction away from second heat exchanger 5. Second surface R2 comes into contact with the external air around fin 11a via insulating film 52 described later. When a temperature difference is formed between first surface R1 and second surface R2, that is, when a temperature difference is formed between fin 11a and the external air around fin 11a, thermoelectric element 50 generates power by the anomalous Nernst effect.

Returning to Fig. 4, thermoelectric element 50 is covered with insulating film 52 having electrical insulation. With such configuration, thermoelectric element 50 is insulated from fin 11a and waterdrops generated by heat exchange of fin 11a, and short circuit of thermoelectric element 50 can be prevented.

Magnetic membrane 51 has a thickness from 1 µm to 100 µm inclusive, and insulating film 52 has a thickness from 1 µm to 50 µm inclusive. Magnetic membrane 51 and insulating film 52 may be formed by sputtering, for example.

A power generation amount of thermoelectric element 50 depends on a length of thermoelectric element 50 extending between terminals 53 described later. The longer thermoelectric element 50 is, the more electric power is generated.

Returning to Fig. 3, thermoelectric element 50 is disposed in a continuous line in fin 11a. In the present description, "line" means a shape having a predetermined width and extending in a straight line, a curved line, or straight line and curved line. The line of thermoelectric element 50 is disposed substantially along the long direction (Z direction) of fins 11a.

In the present exemplary embodiment, thermoelectric element 50 is disposed upstream with respect to the external air (arrow K) supplied by fan 9 on main surface P1 of fin 11a. Here, "upstream" means a region from center line CL1 passing through a position equally away from both ends in the Y direction on main surfaces PI of fin 1 1a to an upstream end of fin 11a to which air is supplied.

More specifically, thermoelectric element 50 includes first thermoelectric element 50A and second thermoelectric element 50B. First thermoelectric element 50A is disposed along the upstream end on main surfaces PI of fin 11a. Second thermoelectric element 50B is disposed around heat transfer tube 14. First thermoelectric element 50A and second thermoelectric element 50B are integrally formed.

First thermoelectric element 50A is disposed in a straight line toward the -Z direction along the upstream end. Second thermoelectric element 50B is disposed in a curved line along protrusion 15 formed around heat transfer tube 14. Second thermoelectric element 50B may be formed along a part of the outer perimeter of protrusion 15, and is formed along the upstream semiperimeter of protrusion 15 in the present exemplary embodiment. Parts of second thermoelectric element 50B formed along the upstream semiperimeter of protrusion 15 are coupled to each other by parts of second thermoelectric element 50B extending in the Z direction. In other words, second thermoelectric element 50B has a part extending in a straight line along center line CL1 and a part extending in an arcuate curved manner upstream of protrusion 15.

First thermoelectric element 50A is coupled to second thermoelectric element 50B near the center of the end of fin 11a. In the present exemplary embodiment, thermoelectric element 50 is disposed so as to make one turn by reciprocating a part of fin 11a once in the long direction.

In the above arrangement, there is a case where first thermoelectric element 50A and second thermoelectric element 50B are arranged close to each other in the Y direction. In this case, a distance between first thermoelectric element 50A and second thermoelectric element 50B is secured in order to avoid contact between first thermoelectric element 50A and second thermoelectric element 50B and thermal conduction between first thermoelectric element 50A and second thermoelectric element 50B. Therefore, the width of each line of first thermoelectric element 50A and second thermoelectric element 50B is preferably small as long as an increase in electric resistance can be suppressed. By reducing the width of the line, the distance between first thermoelectric element 50A and second thermoelectric element 50B close to each other can be easily secured. The width of the line may be, for example, from 5 µm to 100 µm inclusive.

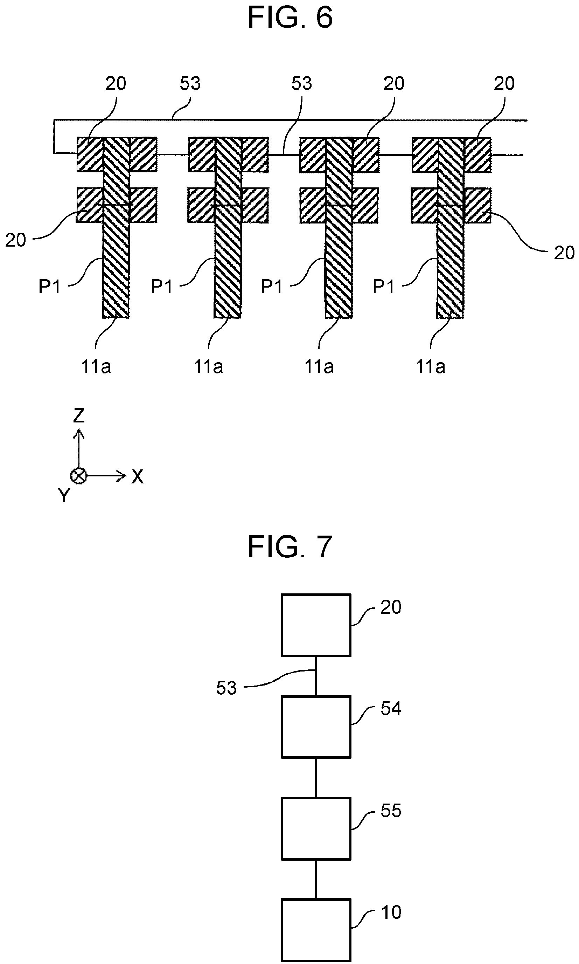

Second heat exchanger 5 has the plurality of thermoelectric members 20, and thermoelectric members 20 are arranged in the plurality of fins 11a. The configuration of the plurality of thermoelectric members 20 will be described with reference to Fig. 6. Fig. 6 is a partial side view illustrating the configuration of second heat exchanger 5. In Fig. 6, insulating films 17 and 52 are not illustrated for the sake of convenience.

As illustrated in Fig. 6, the plurality of thermoelectric members 20 are arranged on both surfaces of respective one of fins 11a. The plurality of thermoelectric members 20 are connected in series for respective one of fins 11a. The plurality of thermoelectric members 20 are electrically connected in series across fins 11a by terminals 53. Terminal 53 may be a lead, a connector, a soldered wire, or the like. Terminal 53 is disposed above second heat exchanger 5. Terminal 53 is provided above fin 11a, and is connected to thermoelectric member 20 disposed above fin 11a.

Thermoelectric member 20 may be electrically connected to another electronic component by terminal 53.

Fig. 7 is a schematic diagram illustrating the configuration of an electronic component related to second heat exchanger 5. As illustrated in Fig. 7, thermoelectric member 20 is electrically connected to rectifier 54, power storage 55, and controller 10 by terminal 53. Rectifier 54 changes the direction in which current flows according to the flow direction of the refrigerant. Rectifier 54 is, for example, a full-wave rectifier circuit. Power storage 55 stores electric power generated by thermoelectric member 20. Heat pump system 100 may use stored electric power at any time.

### [Operation]

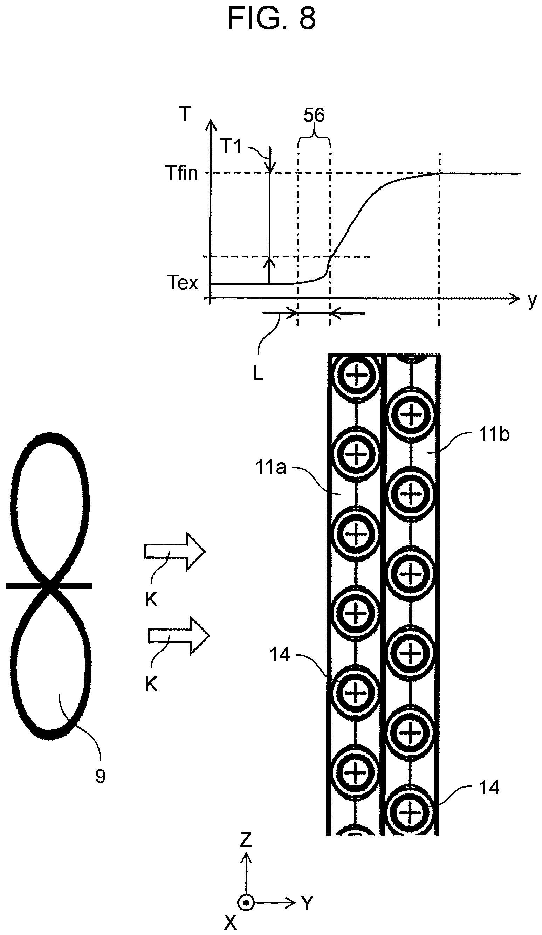

Operation of heat pump system 100 and power generation by thermoelectric member 20 will now be described with reference to Fig. 8. Fig. 8 is a graph illustrating temperature distribution of external air around fins 11a and 11b.

In cooling operation of heat pump system 100, controller 10 actuates compressor 6 to flow the refrigerant through refrigerant pipe 3. The refrigerant proceeds from compressor 6 toward second heat exchanger 5 by four-way valve 8.

Controller 10 rotates fan 9 to supply external air to second heat exchanger 5 along arrow K.

As illustrated in Fig. 8, temperature T of the supplied external air is temperature Tex, which is lower than temperature Tfin of fins 11a and 11b. The supplied external air forms boundary layer 56 in which temperature T rises from temperature Tex upstream of fins 11a. The rotation of fan 9 and the supply of external air suppress an increase in thickness L of boundary layer 56 in the Y direction. Therefore, at the upstream end of fin 11a, temperature difference T1 is formed between temperature Tfin of fin 11a and temperature T of the external air. Thermoelectric element 50 disposed at the upstream end of fin 11a generates electric power corresponding to temperature difference T1.

When the supplied external air further flows in the +Y direction along fins 11a and 1 1b, the external air exchanges heat with fins 11a and 1 1b, the heat of fins 11a and 1 1b moves to the external air, and temperature T of the external air rises. At the downstream end of fin 11b, temperature T of the external air approaches temperature Tfin of fin 11b.

On the other hand, in fin 11a, since protrusion 15 protrudes in the X direction, protrusion 15 is exposed to more external air. Therefore, formation of boundary layer 56 and stay of external air are suppressed in protrusion 15, and temperature difference T1 between fin 11a and temperature T of the external air is maintained. Accordingly, thermoelectric element 50 disposed in protrusion 15 generates electric power corresponding to temperature difference T1.

The electric power generated at thermoelectric element 50 may be used as an input to heat pump system 100. When not used immediately, the electric power generated by thermoelectric element 50 may be transmitted to power storage 55.

### [Effects]

Heat pump system 100 according to the exemplary embodiment can achieve the following effects.

Heat pump system 100 according to the exemplary embodiment includes first heat exchanger 4, compressor 6, second heat exchanger 5, and expansion mechanism 7 that are sequentially connected by refrigerant pipe 3 for circulating a refrigerant. Heat pump system 100 further includes thermoelectric member 20 that is disposed in second heat exchanger 5 and converts a temperature difference into electric energy.

With such configuration, thermoelectric member 20 can efficiently generate power due to the temperature difference generated in second heat exchanger 5. Therefore, heat pump system 100 can improve energy efficiency.

In heat pump system 100, second heat exchanger 5 is disposed outdoors. Thermoelectric member 20 has first surface R1 that is in physical contact with second heat exchanger 5, and second surface R2 that opposes first surface R1 and faces external air.

With such configuration, thermoelectric member 20 can efficiently generate power by the temperature difference generated by heat radiation from second heat exchanger 5 to the external air. In other words, thermoelectric member 20 can convert thermal energy normally discarded to external air by second heat exchanger 5 into reusable electric energy.

In heat pump system 100, thermoelectric element 50 is a vertical thermoelectric element.

With such configuration, thermoelectric element 50 has a smaller thickness and a higher thermal conductivity than those of a normal Seebeck element. Therefore, thermoelectric element 50 can generate power while suppressing an effect of inhibiting heat exchange of heat pump system 100 by thermoelectric element 50. Since the thickness of thermoelectric elements 50 is small, heat pump system 100 can dispose thermoelectric element 50 in second heat exchanger 5 without being limited by an interval between fins 11a. Hence, heat pump system 100 can increase the length of thermoelectric element 50 and increase the power generation amount.

In heat pump system 100, thermoelectric member 20 has magnetic membrane 51 formed of a magnetic material.

With such configuration, thermoelectric member 20 can efficiently generate power due to the anomalous Nernst effect.

In heat pump system 100, the plurality of thermoelectric members 20 are provided, and second heat exchanger 5 includes the plurality of fins 11a and 11b and heat transfer tube 14 that penetrates the plurality of fins 11a and 11b to circulate the refrigerant. The plurality of thermoelectric members 20 are arranged in a line continuous to the plurality of respective fins 11a.

With such configuration, thermoelectric member 20 can efficiently generate power due to the temperature difference generated between the external air and fin 11a.

In heat pump system 100, the plurality of thermoelectric members 20 are connected in series for respective one of fins 11a.

With such configuration, due to an increase in the overall length of thermoelectric member 20, heat pump system 100 can increase the power generation amount in thermoelectric member 20.

Heat pump system 100 further includes fan 9 for supplying external air to the plurality of fins 11a and 11b.

With such configuration, heat pump system 100 can form a flow of external air with respect to second heat exchanger 5 and suppress stay of the external air in second heat exchanger 5. Therefore, heat pump system 100 can form and maintain the temperature difference between second heat exchanger 5 and external air. Therefore, by maintaining the temperature difference between first surface R1 and second surface R2 of thermoelectric member 20, heat pump system 100 can increase the power generation amount of thermoelectric member 20.

In heat pump system 100, the plurality of thermoelectric members 20 are arranged upstream with respect to the external air supplied by fan 9 on main surfaces PI of the plurality of fins 11a.

With such configuration, since thermoelectric member 20 is disposed at a position exposed to external air, the temperature difference between first surface R1 and second surface R2 of thermoelectric member 20 is maintained. Therefore, heat pump system 100 can increase the power generation amount of thermoelectric member 20.

In heat pump system 100, the plurality of thermoelectric members 20 are disposed at upstream ends of the plurality of fins 11a with respect to external air supplied by fan 9.

With such configuration, since thermoelectric member 20 is disposed at a position exposed to more external air, the temperature difference between first surface R1 and second surface R2 of thermoelectric member 20 is maintained. Therefore, heat pump system 100 can further increase the power generation amount of thermoelectric member 20.

In heat pump system 100, the plurality of fins 11a and 11b have protrusions 15 protruding from main surfaces P1 and P2 forming fins 11a and 11b, and thermoelectric member 20 is disposed along protrusions 15 of fins 11a.

With such configuration, since thermoelectric member 20 is disposed at a position exposed to external air, the temperature difference between first surface R1 and second surface R2 of thermoelectric member 20 is maintained. Therefore, heat pump system 100 can increase the power generation amount of thermoelectric member 20.

In heat pump system 100, the plurality of fins 11a and 11b are arranged in first row 12 and second row 13 arranged adjacent to the downstream side of first row 12. Heat transfer tube 14 penetrating first row 12 and heat transfer tube 14 penetrating second row 13 are shifted from each other with respect to the supply direction (arrow K) of external air by fan 9. Thermoelectric member 20 is disposed upstream with respect to the external air supplied by fan 9 on main surfaces PI of the plurality of fins 11a in first row 12.

With such configuration, heat pump system 100 can improve heat exchange efficiency of second heat exchanger 5, and can improve power generation efficiency of thermoelectric member 20.

Heat pump system 100 further includes power storage 55 that is connected to thermoelectric member 20 and stores electric energy converted by thermoelectric member 20.

With such configuration, heat pump system 100 can store generated electric power.

Heat pump system 100 further includes four-way valve 8 that changes the direction in which the refrigerant flows in refrigerant pipe 3, and rectifier 54 that is connected to thermoelectric member 20 and changes the direction of the current according to the direction in which the refrigerant flows.

With such configuration, heat pump system 100 can use electric power generated by thermoelectric member 20 even when a direction in which the refrigerant flows is changed and a temperature gradient in thermoelectric member 20 is reversed.

In heat pump system 100, terminal 53 connected to thermoelectric member 20 is disposed above second heat exchanger 5.

With such configuration, heat pump system 100 can increase the overall length of thermoelectric member 20 to increase the power generation amount. Heat pump system 100 can suppress terminal 53 from hindering drainage of water adhering to second heat exchanger 5 due to heat exchange.

Note that the present disclosure is not limited to the exemplary embodiment, and can be carried out in various other aspects. In the exemplary embodiment, the air conditioner in cooling operation has been described as an example of heat pump system 100, but heat pump system 100 is not limited to this. For example, heat pump system 100 may be an air conditioner in heating operation. Heat pump system 100 may be a water heater.

It has been described that thermoelectric member 20 includes thermoelectric element 50 that exerts the thermoelectric effect, but the present disclosure is not limited to this. Thermoelectric member 20 may include another electronic component, material, and the like that convert thermal energy into electric energy instead of or in addition to thermoelectric element 50. For example, thermoelectric member 20 may be a film that converts thermal energy into electric energy. Thermoelectric member 20 may have an element that generates power along a direction in which a temperature difference is generated instead of or in addition to thermoelectric element 50, which is a vertical thermoelectric element.

In the exemplary embodiment, an example in which thermoelectric member 20 is disposed in second heat exchanger 5 has been described, but the present disclosure is not limited to this. For example, thermoelectric member 20 may be disposed in first heat exchanger 4, or may be disposed in both first heat exchanger 4 and second heat exchanger 5.

In the exemplary embodiment, an example in which second heat exchanger 5 includes fins 11a and 11b and heat transfer tube 14 penetrating fins 11a and 11b has been described, but the present disclosure is not limited to this. In order to circulate the refrigerant, second heat exchanger 5 is only required to have the heat transfer flow channel mechanism that forms a flow channel through which the refrigerant flows inside. For example, the heat transfer flow channel mechanism includes a coil instead of or in addition to heat transfer tube 14 in a straight shape. Second heat exchanger 5 may be a heat exchanger in which a heat transfer flow channel mechanism such as heat transfer tube 14 does not penetrate fins 11a and 11b. The heat transfer flow channel mechanism only needs to be in contact with fins 11a and 11b. That is, second heat exchanger 5 is only required to have a heat transfer flow channel mechanism that is in contact with the plurality of fins 11a and 11b and circulates the refrigerant. For example, second heat exchanger 5 may be a plate fin heat exchanger.

In the exemplary embodiment, an example in which fins 11a and 11b are arranged to form two rows, first row 12 and second row 13, has been described, but the present disclosure is not limited to this. For example, fins 11a and 11b may be arranged in one row or in three or more rows.

In the exemplary embodiment, an example in which fins 11a and 11b form protrusion 15 has been described, but the present disclosure is not limited to this. For example, fins 11a and 11b may be flat plate-like members that do not have protrusion 15. In this case, thermoelectric member 20 may also be formed along the upstream semiperimeter of the outer perimeter of heat transfer tube 14.

In the exemplary embodiment, an example in which thermoelectric member 20 is disposed in fins 11a of first row 12 has been described, but the present disclosure is not limited to this. For example, thermoelectric member 20 may be disposed upstream of the plurality of fins 11a in first row 12 and upstream of the plurality of fins 11b in second row 13. With such configuration, the heat pump system according to the present modification can further increase the power generation amount by lengthening thermoelectric member 20.

In the exemplary embodiment, an example in which thermoelectric member 20 is disposed on both surfaces of fins 11a has been described, but the present disclosure is not limited to this. Thermoelectric member 20 may be formed only on a surface of fin 11a that is easily exposed to the external air.

In the exemplary embodiment, an example in which the line of thermoelectric element 50 is disposed along the long direction (Z direction) of fins 11a has been described, but the present disclosure is not limited to this. The plurality of thermoelectric elements 50 may meander. The lines of thermoelectric elements 50 may be partially or entirely curved while avoiding contact with other parts of the lines. With such configuration, the heat pump system according to the present modification can further increase the length of thermoelectric element 50 and increase the power generation amount.

In the exemplary embodiment, an example in which thermoelectric element 50 is folded back near the center of the end of fins 11a has been described, but the present disclosure is not limited to this. Thermoelectric element 50 may be formed only above fin 11a so as not to hinder drainage of second heat exchanger 5.

In the exemplary embodiment, an example in which thermoelectric member 20 is connected by terminal 53 has been described, but the present disclosure is not limited to this. Instead of terminal 53, fin 11a is bent and thermoelectric members 20 disposed on adjacent fins 11a are brought into contact with each other, whereby thermoelectric members 20 may be connected.

In the exemplary embodiment, an example in which a part of thermoelectric member 20 is disposed along protrusion 15 has been described, but the present disclosure is not limited to this. The thermoelectric member 20 may be formed on fin 11a in contact with the outer perimeter of heat transfer tube 14 instead of protrusion 15. With such configuration, since thermoelectric member 20 is disposed at a position where heat exchange is performed, the temperature difference in thermoelectric member 20 can be increased. As in the first modification described later, thermoelectric element 50 included in thermoelectric member 20 may be arranged so as to form one turn along the upstream end of fin 11a.

In the exemplary embodiment, an example in which thermoelectric element 50 is disposed so as to form one turn has been described, but the present disclosure is not limited to this. For example, as in the second modification described later, thermoelectric element 50 may be arranged so as to form two turns. Thermoelectric element 50 may be arranged so as to form three or more turns.

In the exemplary embodiment, as illustrated in Fig. 2, an example in which the orientation of the external air supplied by fan 9 becomes the Y direction (arrow K) is illustrated. However, the orientation of the air blown by fan 9 is not limited to this, and the fan may be configured such that the orientation of the external air becomes the -Y direction. Also in this case, as described above, thermoelectric member 20 is preferably disposed upstream with respect to the external air supplied by the fan on the main surfaces of the plurality of fins 11a and 11b. That is, when the orientation of the external air is the -Y direction in Fig. 2, thermoelectric member 20 is preferably disposed in the rearmost side (the side opposite to the side where fan 9 is disposed) of second heat exchanger 5 of outdoor equipment 2.

### (First modification)

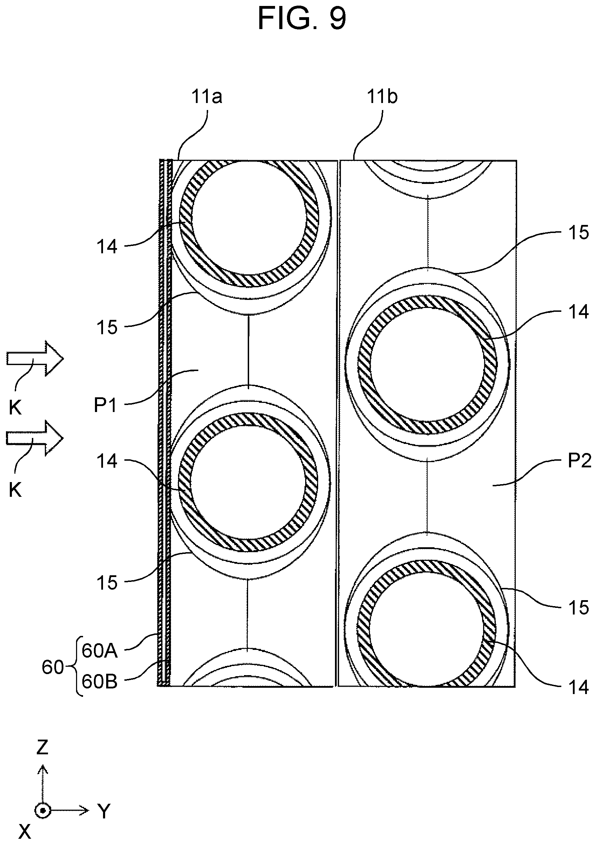

Fig. 9 is a view illustrating the arrangement of thermoelectric element 60 according to the first modification of the exemplary embodiment. As illustrated in Fig. 9, thermoelectric element 60 is disposed in a continuous line in fin 11a.

The first modification is different from thermoelectric element 50 of the exemplary embodiment in that more of thermoelectric element 60 is disposed at the upstream end on main surface PI of fin 11a. More specifically, thermoelectric element 60 includes first thermoelectric element 60A and second thermoelectric element 60B. First thermoelectric element 60A is disposed along the upstream end on main surfaces PI of fin 11a. Second thermoelectric element 60B is disposed downstream of first thermoelectric element 60A along first thermoelectric element 60A on upstream relative to heat transfer tube 14. First thermoelectric element 60A and second thermoelectric element 60B are integrally formed.

First thermoelectric element 60A extends in a straight line toward the -Z direction along the upstream end. Second thermoelectric element 60B extends in a straight line toward the +Z direction. Second thermoelectric element 60B is disposed in fin 11a on the center side relative to first thermoelectric element 60A with an interval from first thermoelectric element 60A.

With such configuration, that is, by disposing thermoelectric element 60 at the site of fin 11a where temperature T of the external air is low, it is possible to form a temperature difference between first surface R1 and second surface R2 of thermoelectric element 60. Therefore, the heat pump system of the first modification can improve the power generation amount of thermoelectric element 60.

### (Second modification)

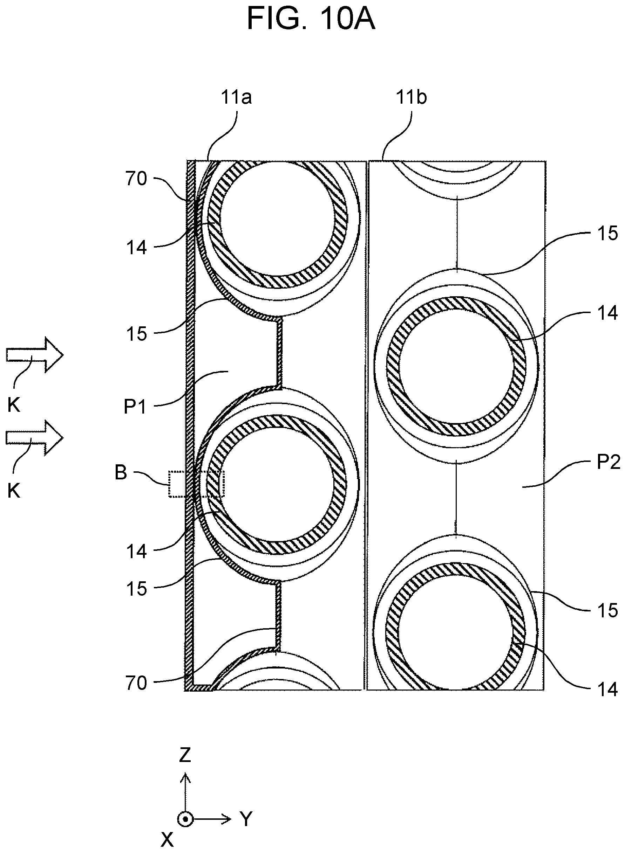

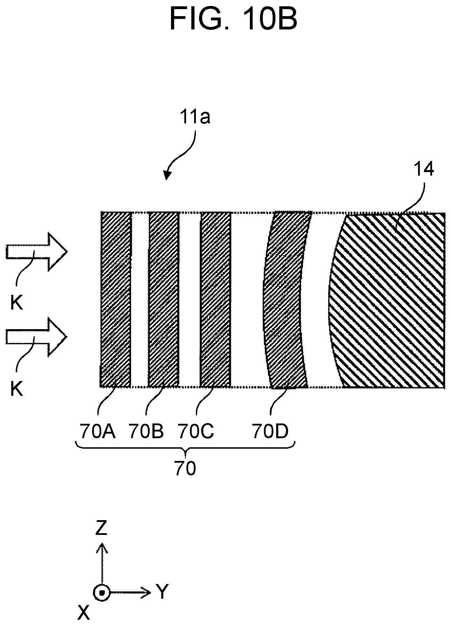

Fig. 10A is a view illustrating the arrangement of thermoelectric element 70 according to the second modification of the exemplary embodiment. Fig. 10B is a partially enlarged view illustrating the configuration of thermoelectric element 70 in Fig. 10A, and illustrates a part indicated by B in Fig. 10A. As illustrated in Figs. 10A and 10B, thermoelectric element 70 is disposed in a continuous line in fin 11a.

The second modification is different from thermoelectric element 50 of the exemplary embodiment in that the number of turns of thermoelectric element 70 is increased on main surface PI of fin 11a. More specifically, thermoelectric element 70 is formed with two turns. Thermoelectric element 70 includes first thermoelectric element 70A and second thermoelectric element 70B that constitute a first turn, and third thermoelectric element 70C and fourth thermoelectric element 70D that constitute a second turn. First thermoelectric element 70A is disposed along the upstream end on main surfaces PI of fin 11a. Second thermoelectric element 70B, third thermoelectric element 70C, and fourth thermoelectric element 70D are sequentially arranged downstream of first thermoelectric element 70A. First thermoelectric element 70A, second thermoelectric element 70B, third thermoelectric element 70C, and fourth thermoelectric element 70D are integrally formed.

First thermoelectric element 70A is disposed along the upstream end on main surfaces PI of fin 11a. Second thermoelectric element 70B is disposed downstream of first thermoelectric element 70A along first thermoelectric element 70A on upstream relative to heat transfer tube 14. Third thermoelectric element 70C is disposed in fin 11a on the center side relative to second thermoelectric element 70B with an interval from second thermoelectric element 70B, and extends in a straight line toward the -Z direction. Fourth thermoelectric element 70D is disposed in a curved line along protrusion 15 formed around heat transfer tube 14. Fourth thermoelectric element 70D may be formed along a part of the outer perimeter of protrusion 15, and is formed along the upstream semiperimeter of protrusion 15 in the second modification. Parts of fourth thermoelectric elements 70D formed along the upstream semiperimeter of protrusion 15 are coupled to each other by parts of fourth thermoelectric element 70D extending in the Z direction.

Such configuration allows the heat pump system of the second modification to have thermoelectric element 70 formed long and increase the power generation amount of the thermoelectric element 70 while concentrating thermoelectric elements 70 upstream of fins 11a where the temperature difference is formed between fins 11a and the external air.

Third thermoelectric element 70C and fourth thermoelectric element 70D of the second turn may extend in a straight line, similarly to first thermoelectric element 70A and second thermoelectric element 70B of the first turn.

In the exemplary embodiment, an example in which thermoelectric element 50 has magnetic membrane 51 has been described, but the present disclosure is not limited to this. For example, as in the third modification described later, the thermoelectric element according to the exemplary embodiment of the present disclosure may have a membrane other than magnetic membrane 51.

### (Third modification)

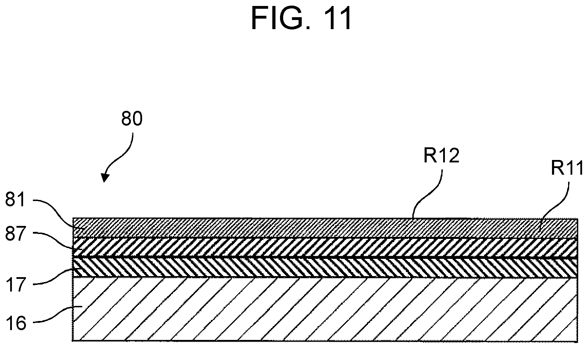

Fig. 11 is a view illustrating the configuration of thermoelectric element 80 of the third modification. Thermoelectric element 80 includes insulating film 87 that forms first surface R11 and is made of an electric insulator having magnetism, and conductive membrane 81 that is disposed on insulating film 87, forms second surface R12, and is made of an electric conductor. With such configuration, the thermoelectric member of the third modification including thermoelectric element 80 can efficiently generate power by the spin Seebeck effect. Since thermoelectric element 80 has insulating film 87 between thermoelectric element 80 and base material 16, thermoelectric element 80 can also be applied to a fin in which insulating film 17 is not formed.

Although the present disclosure has been fully described in connection with preferable exemplary embodiments with reference to the accompanying drawings, various modifications and changes are obvious to those skilled in the art. Such modifications and changes are to be understood as being included within the scope of the appended claims as long as they do not depart from the scope of the appended claims.

The heat pump system of the present disclosure can recover exhaust heat as electric power and improve recovery efficiency of exhaust heat. The heat pump system of the present disclosure is useful as, for example, an air conditioner, a water heater, and the like.

## Claims

1. A heat pump system (100) comprising: a first heat exchanger (4), a compressor (6), a second heat exchanger (5), and an expansion mechanism (7) that are sequentially connected by a refrigerant pipe (3) that circulates a refrigerant,
wherein the heat pump system (100) further comprises a thermoelectric member (20) that is disposed in at least one of the first heat exchanger (4) and the second heat exchanger (5) and converts a temperature difference into electric energy.

2. The heat pump system (100) according to claim 1, wherein
the second heat exchanger (5) is disposed outdoors (1), and
the thermoelectric member (20) includes a first surface (R1) that is in physical contact with the second heat exchanger (5), and a second surface (R2) that opposes the first surface (R1) and faces external air.

3. The heat pump system (100) according to claim 2, wherein the thermoelectric member (20) is a vertical thermoelectric element (50),
wherein, preferably, the thermoelectric member (20) includes a magnetic membrane formed of a magnetic material, or
wherein, preferably,
the thermoelectric member (20) includes
an insulating film that forms the first surface and is formed of a magnetic insulator, and
a conductive membrane that is disposed on the insulating film, forms the second surface (R2), and is formed of a conductor.

4. The heat pump system (100) according to any one of claims 1 to 3, wherein
the second heat exchanger (5) includes a plurality of fins (11a/11b) and a heat transfer flow channel mechanism that comes into contact with the plurality of fins (11a/11b) and circulates the refrigerant,
the thermoelectric member (20) is a plurality of thermoelectric members, and
the plurality of thermoelectric members are arranged in a line continuous to the plurality of respective fins (1 1a/11b).

5. The heat pump system (100) according to claim 4, wherein the plurality of thermoelectric members (20) are connected in series for each fin.

6. The heat pump system (100) according to claim 4 or 5, wherein the plurality of thermoelectric members (20) meander.

7. The heat pump system (100) according to any one of claims 4 to 6 further comprising a fan (9) for supplying external air to the plurality of fins (1 1a/11b).

8. The heat pump system (100) according to claim 7, wherein the plurality of thermoelectric members (20) are arranged upstream with respect to external air supplied by the fan (9) on main surfaces (P1/P2) of the plurality of fins (1 1a/11b).

9. The heat pump system (100) according to claim 8, wherein the plurality of thermoelectric members (20) are arranged at upstream ends of the plurality of fins (11a/11b) with respect to external air supplied by the fan (9).

10. The heat pump system (100) according to any one of claims 7 to 9, wherein the plurality of thermoelectric members (20) are arranged in the plurality of fins (11a/11b) around the heat transfer flow channel mechanism.

11. The heat pump system according to any one of claims 7 to 10, wherein
the plurality of fins (11a/11b) include a protrusion (15) protruding from a main surface (P1/P2) forming the fins, and
the plurality of thermoelectric members (20) are arranged along the protrusion (15).

12. The heat pump system (100) according to claim 11, wherein
the plurality of fins (1 1a/11b) are arrayed in a first row (12) and a second row (13) arranged adjacent to a downstream side of the first row (12),
the heat transfer flow channel mechanism includes a heat transfer tube (14) penetrating the plurality of fins (1 1a/11b),
the heat transfer tube (14) penetrating the first row (12) and the heat transfer tube (14) penetrating the second row (13) are shifted from each other with respect to a supply direction of external air by the fan (9), and
the plurality of thermoelectric members are arranged upstream with respect to external air supplied by the fan (9) on main surfaces (P1/P2) of the plurality of fins (11a/11b) in the first row (12) and the second row (13).

13. The heat pump system (100) according to any one of claims 1 to 12 further comprising a power storage (55) that is connected to the thermoelectric member (20) and stores the electric energy converted by the thermoelectric member (20).

14. The heat pump system (100) according to any one of claims 1 to 13, further comprising:
a four-way valve (8) that changes a direction in which the refrigerant flows in the refrigerant pipe (3); and
a rectifier (54) that is connected to the thermoelectric member (20) and changes a direction of a current according to a direction in which the refrigerant flows.

15. The heat pump system (100) according to any one of claims 1 to 14, wherein a terminal (53) connected to the thermoelectric member (20) is disposed above the second heat exchanger (5).
